# EUROPEAN PATENT APPLICATION

(11) **EP 4 391 035 A1**
(43) Date of publication of application: **26.06.2024**
(21) Application number: 23214676.1
(22) Date of filing: 06.12.2023
(51) Int. Cl.: H01L 21/768, H01L 23/522, H01L 23/532, H10B 12/00

(54) **WIRING STRUCTURE AND SEMICONDUCTOR DEVICE INCLUDING THE SAME**

(30) Priority: 12.12.2022 KR 20220173061
(71) Applicant: Samsung Electronics Co., Ltd., Suwon-si, Gyeonggi-do 16677 (KR)
(72) Inventor: KWON, Donghoon, 16677 Suwon-si (KR); LEE, Yanghee, 16677 Suwon-si (KR); PARK, Jonghyuk, 16677 Suwon-si (KR)
(74) Representative: Marks & Clerk LLP

(57) **Abstract**

A wiring structure includes a lower insulating layer; a lower wiring structure extending in a vertical direction and passing through the lower insulating layer; a spacer surrounding a side wall of the lower wiring structure; a capping insulating layer on the lower insulating layer; and a via structure extending in the vertical direction and passing through the capping insulating layer, wherein the via structure overlaps the lower wiring structure and the spacer in the vertical direction, and the via structure includes a protruding portion extending in the vertical direction and passing through at least a portion of the spacer.

## Description

### BACKGROUND

### 1. Field

Embodiments relate to a wiring structure and a semiconductor device including the wiring structure.

### 2. Description of the Related Art

Along with the development of the electronics industry, semiconductor devices tend to have high performance and a small size. Accordingly, a plurality of semiconductor elements included in a semiconductor device have also been highly integrated and miniaturized. In addition, the semiconductor device includes a wiring structure, which connects semiconductor elements to each other. According to the trend of high integration and miniaturization of semiconductor elements, a wiring structure may connect the semiconductor elements to each other.

### SUMMARY

The embodiments may be realized by providing a wiring structure including According to an aspect of the inventive concept, there is provided a wiring structure including a lower insulating layer; a lower wiring structure extending in a vertical direction and passing through the lower insulating layer; a spacer surrounding a side wall of the lower wiring structure; a capping insulating layer on the lower insulating layer; and a via structure extending in the vertical direction and passing through the capping insulating layer, wherein the via structure overlaps the lower wiring structure and the spacer in the vertical direction, and the via structure includes a protruding portion extending in the vertical direction and passing through at least a portion of the spacer.

The embodiments may be realized by providing a semiconductor device including a substrate; a plurality of capacitor structures including a plurality of lower electrodes on the substrate, a capacitor dielectric layer covering the plurality of lower electrodes, and an upper electrode filling a space between the plurality of lower electrodes and covering an upper surface of the capacitor dielectric layer; and a wiring structure on and connected to the plurality of capacitor structures, wherein the wiring structure includes a lower insulating layer on the substrate; a lower wiring structure extending in a vertical direction and passing through the lower insulating layer; a spacer surrounding a side wall of the lower wiring structure; a capping insulating layer on the lower insulating layer; and a via structure extending in the vertical direction and passing through the capping insulating layer, wherein the via structure overlaps the lower wiring structure and the spacer in the vertical direction, and the via structure includes a protruding portion extending in the vertical direction and passing through at least a portion of the spacer.

The embodiments may be realized by providing a wiring structure including a lower insulating layer; a plurality of lower wiring structures extending in a vertical direction and passing through the lower insulating layer; a spacer surrounding a side wall of the lower wiring structure; a capping insulating layer including a first capping insulating layer and a second capping insulating layer sequentially on the lower insulating layer; an upper insulating layer on the capping insulating layer; and a first via structure and a second via structure separated from each other, extending in the vertical direction, and passing through the upper insulating layer and the capping insulating layer, wherein the first via structure overlaps the lower wiring structure and the spacer in the vertical direction, the second via structure overlaps the lower wiring structure in the vertical direction, and the first via structure includes a protruding portion extending in the vertical direction and passing through at least a portion of the spacer.

At least some of the above and other features of the invention are set out in the claims.

### BRIEF DESCRIPTION OF THE DRAWINGS

Features will be apparent to those of skill in the art by describing in detail example embodiments with reference to the attached drawings in which:
FIG. 1 is a plane layout illustrating a semiconductor device according to an embodiment;
FIG. 2A is a cross-sectional view illustrating the semiconductor device according to an embodiment; FIG. 2B is a cross-sectional view illustrating the semiconductor device according to an embodiment;
FIG. 3A is a magnified cross-sectional view of region EX1 of FIG. 2A, and FIG. 3B is a magnified cross-sectional view of region EX2 of FIG. 3A;
FIG. 4 is a cross-sectional view illustrating a partial region of a semiconductor device according to an embodiment;
FIG. 5 is a cross-sectional view illustrating a partial region of a semiconductor device according to an embodiment;
FIG. 6 is a cross-sectional view illustrating a partial region of a semiconductor device according to an embodiment; and
FIGS. 7A to 7H are cross-sectional views of stages in a method of manufacturing a semiconductor device, according to an embodiment.

### DETAILED DESCRIPTION

Hereinafter, embodiments are described in detail with reference to the accompanying drawings. Like reference numerals in the drawings denote like elements, and thus their repetitive description is omitted.

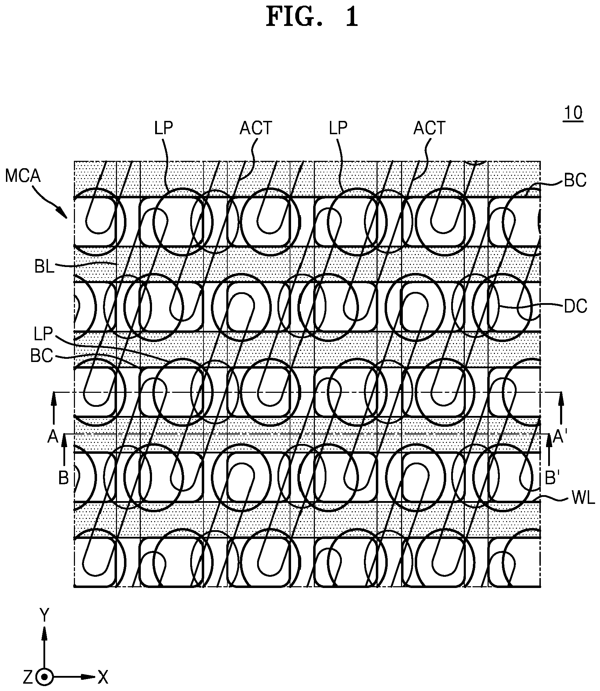

FIG. 1 is a plane layout illustrating a semiconductor device 10 according to an embodiment.

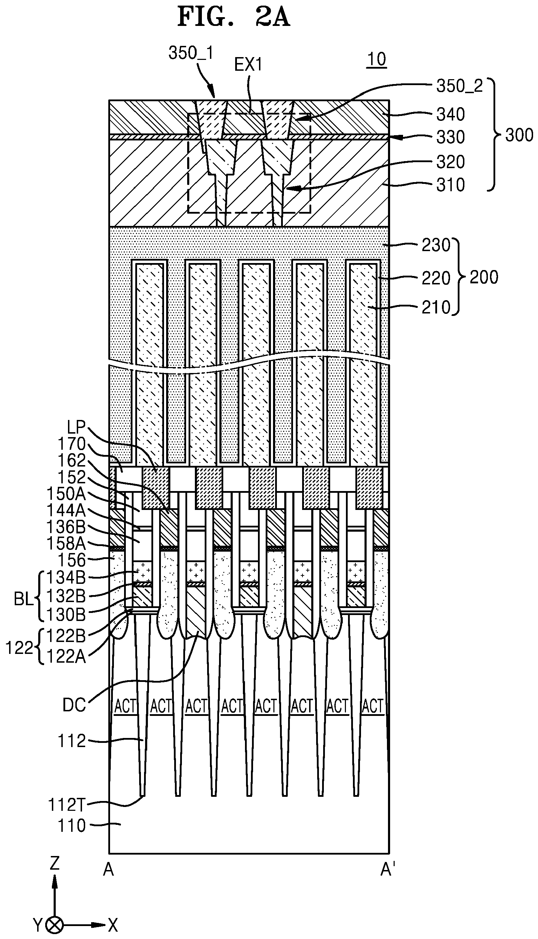

Referring to FIG. 1, the semiconductor device 10 may include a cell array area MCA. The cell array area MCA may include a plurality of cell active regions ACT. Each of the plurality of cell active regions ACT may have a long axis in a diagonal direction with respect to a first horizontal direction (an X direction) and a second horizontal direction (a Y direction). In the present context, a horizontal direction may be a direction that is parallel to an upper surface of a substrate of the semiconductor device 10. Similarly, a vertical direction may be a direction perpendicular to the upper surface of the substrate of the semiconductor device 10. The first horizontal direction (the X direction) and the second horizontal direction (the Y direction) may intersect each other. For instance, the first horizontal direction (the X direction) and the second horizontal direction (the Y direction) may be perpendicular to each other. An "upper" section of a component may be higher than (e.g. further along the vertical direction) than a "lower" section of the component. It will be appreciated that terms such as "vertical", "horizontal", "upper" and "lower" are relative to the structure of the semiconductor device 10, and need not imply any particular orientation of the semiconductor device 10 in use. A plurality of word lines WL may extend (e.g., lengthwise) in parallel to each other in the first horizontal direction (the X direction) and cross the plurality of cell active regions ACT. Above the plurality of word lines WL, a plurality of bit lines BL may extend in parallel to each other in the second horizontal direction (the Y direction). The plurality of bit lines BL may be connected to the plurality of cell active regions ACT via a plurality of direct contacts DC. A plurality of buried contacts BC may be between two adjacent bit lines BL among the plurality of bit lines BL. The plurality of buried contacts BC may be arranged in a line in the first horizontal direction (the X direction) and the second horizontal direction (the Y direction). A plurality of conductive landing pads LP may be respectively on the plurality of buried contacts BC. The plurality of buried contacts BC and the plurality of conductive landing pads LP may connect lower electrodes 210 (see FIG. 2A) of a capacitor structure 200 (see FIG. 2A) above the plurality of bit lines BL to the plurality of cell active regions ACT. The plurality of conductive landing pads LP may partially overlap the plurality of buried contacts BC, respectively.

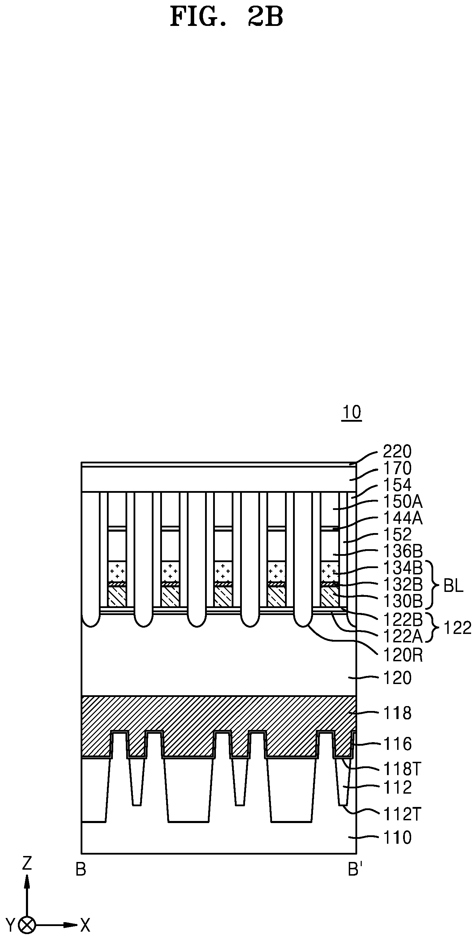

FIGS. 2A and 2B are cross-sectional views illustrating the semiconductor device 10 according to an embodiment. Particularly, FIG. 2A is a cross-sectional view taken along line A-A' of FIG. 1, and FIG. 2B is a cross-sectional view taken along line B-B' of FIG. 1.

Referring to FIGS. 2A and 2B, the semiconductor device 10 may include a substrate 110 having the cell array area MCA. An isolation layer trench 112T may be in the substrate 110, and an isolation layer 112 may be in the isolation layer trench 112T. In or on the cell array area MCA, the plurality of cell active regions ACT in the substrate 110 may be defined by the isolation layer 112.

The substrate 110 may include silicon (Si), e.g., monocrystalline Si, polycrystalline Si, or amorphous Si. In an implementation, the substrate 110 may include germanium (Ge), silicon germanium (SiGe), silicon carbide (SiC), gallium arsenide (GaAs), indium arsenide (InAs), or indium phosphide (InP). In an implementation, the substrate 110 may include a conductive region, e.g., an impurity-doped well or an impurity-doped structure. The isolation layer 112 may include an oxide layer, a nitride layer, or a combination thereof. As used herein, the term "or" is not an exclusive term, e.g., "A or B" would include A, B, or A and B.

On the cell array area MCA, a plurality of word line trenches 118T extending in the first horizontal direction (the X direction) may be in the substrate 110, and a plurality of gate dielectric layers 116, a plurality of word lines 118, and a plurality of buried insulating layers 120 may be in the plurality of word line trenches 118T, respectively. The plurality of word lines 118 may respectively correspond to the plurality of word lines WL shown in FIG. 1. A plurality of recess spaces 120R may be in an upper surface of a buried insulating layer 120.

The plurality of gate dielectric layers 116 may include a silicon oxide (SiO₂) layer, a silicon nitride (SiN) layer, a silicon oxynitride (SiON) layer, an oxide/nitride/oxide (ONO) layer, or a high-k dielectric layer (e.g. a layer having a higher dielectric constant than a SiO₂ layer). In an implementation, the plurality of gate dielectric layers 116 may include, e.g., hafnium dioxide (HfO₂), aluminum oxide (Al₂O₃), hafnium aluminum oxide (HfAlOs), tantalum trioxide (Ta₂O₃), or titanium dioxide (TiO₂). The plurality of word lines 118 may include, e.g., titanium (Ti), titanium nitride (TiN), tantalum (Ta), tantalum nitride (TaN), tungsten (W), tungsten nitride (WN), titanium silicon nitride (TiSiN), tungsten silicon nitride (WSiN), or a combination thereof. The plurality of buried insulating layers 120 may include, e.g., a SiO₂ layer, a SiN layer, a SiON layer, or a combination thereof.

A buffer layer 122 may be on the substrate 110. The buffer layer 122 may include a first insulating layer 122A and a second insulating layer 122B. Each of the first insulating layer 122A and the second insulating layer 122B may include an oxide layer, a nitride layer, or a combination thereof. The plurality of direct contacts DC may be on the substrate 110. The plurality of direct contacts DC may be connected to the plurality of cell active regions ACT, respectively. The plurality of direct contacts DC may include, e.g., Si, Ge, W, WN, cobalt (Co), nickel (Ni), aluminum (Al), molybdenum (Mo), ruthenium (Ru), Ti, TiN, Ta, TaN, copper (Cu), or a combination thereof.

On the substrate 110 and the plurality of direct contacts DC, the plurality of bit lines BL may extend lengthwise in the second horizontal direction (the Y direction). Each of the plurality of bit lines BL may be connected to a cell active region ACT via a direct contact DC. Each of the plurality of bit lines BL may include a lower conductive pattern 130B, an intermediate conductive pattern 132B, and an upper conductive pattern 134B sequentially stacked on the substrate 110.

The lower conductive pattern 130B may include doped polysilicon. Each of the intermediate conductive pattern 132B and the upper conductive pattern 134B may include TiN, TiSiN, W, tungsten silicide, or a combination thereof. In an implementation, the intermediate conductive pattern 132B may include TiN, TiSiN, or a combination thereof, and the upper conductive pattern 134B may include W. On each of the plurality of bit lines BL, a lower insulating capping pattern 136B, an insulating thin-film pattern 144A, and an upper insulating capping pattern 150A sequentially covering an upper surface of the bit line BL may be disposed. In an implementation, the lower insulating capping pattern 136B, the insulating thin-film pattern 144A, and the upper insulating capping pattern 150A may be referred to as an insulating capping pattern. Each of the lower insulating capping pattern 136B, the insulating thin-film pattern 144A, and the upper insulating capping pattern 150A may include a SiN layer.

Side walls of each of the plurality of bit lines BL and side walls of an insulating capping pattern including the lower insulating capping pattern 136B, the insulating thin-film pattern 144A, and the upper insulating capping pattern 150A may be covered by a pair of insulating spacers 152 among a plurality of insulating spacers 152. The plurality of insulating spacers 152 may extend lengthwise in the second horizontal direction (the Y direction) to be parallel to the plurality of bit lines BL. The plurality of insulating spacers 152 may include an oxide layer, a nitride layer, an air spacer, or a combination thereof. In the specification, the term "air" may indicate a space including the atmosphere or other gases, which may exist during a manufacturing process. For instance, "air" may indicate a space including a combination of nitrogen and oxygen (and optionally one or more additional gasses). The bit line BL, the lower insulating capping pattern 136B, the insulating thin-film pattern 144A, the upper insulating capping pattern 150A, and the pair of insulating spacers 152 covering both side walls of each thereof may constitute a bit line structure.

A plurality of lower contact plugs 156 and a plurality of insulating fences 154 may be in a line in the second horizontal direction (the Y direction) between every two of the plurality of bit lines BL. The plurality of lower contact plugs 156 may extend lengthwise to the inside of the substrate 110 in a vertical direction (a Z direction). Each of the plurality of lower contact plugs 156 may be electrically connected to one cell active region ACT of the plurality of cell active regions ACT. The plurality of insulating fences 154 may be between every two of the plurality of lower contact plugs 156 while filling the plurality of recess spaces 120R formed in an upper surface of the buried insulating layer 120. In the second horizontal direction (the Y direction), both side walls of each of the plurality of lower contact plugs 156 may be covered by each pair of the plurality of insulating fences 154. The plurality of lower contact plugs 156 arranged in a line in the second horizontal direction (the Y direction) may be insulated from each other by the plurality of insulating fences 154. The plurality of lower contact plugs 156 may constitute the plurality of buried contacts BC shown in FIG. 1. Each of the plurality of lower contact plugs 156 may be separated from a bit line BL with an insulating spacer 152 therebetween in the first horizontal direction (the X direction). The plurality of lower contact plugs 156 may include doped polysilicon. The plurality of insulating fences 154 may include a SiN layer.

A plurality of metal silicide layers 158A and a plurality of contact plugs 162 may be sequentially on the plurality of lower contact plugs 156. Each of the plurality of metal silicide layers 158A and each of the plurality of contact plugs 162 may overlap a lower contact plug 156 in the vertical direction (the Z direction). In an implementation, the plurality of metal silicide layers 158A may be omitted. The plurality of metal silicide layers 158A may include cobalt silicide, nickel silicide, or manganese silicide. Each of the plurality of contact plugs 162 may be connected to a lower contact plug 156 via a metal silicide layer 158A. Each of the plurality of contact plugs 162 may be separated from the lower insulating capping pattern 136B, the insulating thin-film pattern 144A, and the upper insulating capping pattern 150A with an insulating spacer 152 therebetween in the first horizontal direction (the X direction). The plurality of contact plugs 162 may include a metal, conductive metal nitride, or a combination thereof. In an implementation, each of the plurality of contact plugs 162 may include TiN, W, or a combination thereof.

The plurality of conductive landing pads LP may respectively overlap the plurality of contact plugs 162 in the vertical direction (the Z direction). Each of the plurality of conductive landing pads LP may be electrically connected to a contact plug 162 and electrically connected to a lower contact plug 156 via the contact plug 162 and a metal silicide layer 158A. Each of the plurality of conductive landing pads LP may include a metal, conductive metal nitride, or a combination thereof. In an implementation, each of the plurality of conductive landing pads LP may include TiN, W, or a combination thereof. The plurality of conductive landing pads LP may have a pattern shape of a plurality of islands in a top view.

In an implementation, the plurality of contact plugs 162 and the plurality of conductive landing pads LP may include the same metal. In an implementation, each of the plurality of contact plugs 162 and the plurality of conductive landing pads LP may include a TiN layer only. In an implementation, the plurality of contact plugs 162 and the plurality of conductive landing pads LP may include different metals. In an implementation, each of the plurality of contact plugs 162 and the plurality of conductive landing pads LP may include a stacked structure of a TiN barrier layer and a W layer.

An insulating pattern 170 may be on a plurality of upper insulating capping patterns 150A, the plurality of insulating spacers 152, and the plurality of contact plugs 162. The insulating pattern 170 may insulate the plurality of conductive landing pads LP from each other by surrounding the plurality of conductive landing pads LP. The insulating pattern 170 may include SiN, SiO₂, or SiON.

A capacitor structure 200 may be on the plurality of conductive landing pads LP. The capacitor structure 200 may include a plurality of lower electrodes 210, a capacitor dielectric layer 220, and an upper electrode 230.

The plurality of lower electrodes 210 may be electrically connected to the plurality of conductive landing pads LP, respectively. In an implementation, each of the plurality of lower electrodes 210 may have a pillar shape. In an implementation, each of the plurality of lower electrodes 210 may have a cylindrical shape. In an implementation, the plurality of lower electrodes 210 may be arranged in a honeycomb shape. In an implementation, the plurality of lower electrodes 210 may be arranged in a matrix shape. Each of the plurality of lower electrodes 210 may include impurity-doped Si, a metal, or a conductive metal compound.

The capacitor dielectric layer 220 may cover upper surfaces of the plurality of conductive landing pads LP, an upper surface of the insulating pattern 170, and the plurality of lower electrodes 210. In an implementation, the capacitor dielectric layer 220 may conformally cover the upper surfaces of the plurality of conductive landing pads LP, the upper surface of the insulating pattern 170, and the plurality of lower electrodes 210. The capacitor dielectric layer 220 may include, e.g., tantalum oxide (TaO), tantalum aluminum oxide (TaAlO), tantalum oxynitride (TaON), aluminum oxide (AlO), aluminum silicon oxide (AlSiO), hafnium oxide (HfO), hafnium silicon oxide (HfSiO), zirconium oxide (ZrO), zirconium silicon oxide (ZrSiO), titanium oxide (TiO), titanium aluminum oxide (TiAlO), barium strontium titanium oxide ((Ba, Sr)TiO (BST)), strontium titanium oxide (SrTiO (STO)), barium titanium oxide (BrTiO (BTO)), lead zirconium titanium oxide (Pb(Zr, Ti)O (PZT), lead lanthanum zirconium titanium oxide ((Pb, La)(Zr, Ti)O), barium zirconium titanium oxide (Ba(Zr, Ti)O), strontium zirconium titanium oxide (Sr(Zr, Ti)O), or a combination thereof.

The upper electrode 230 may fill a space between the plurality of lower electrodes 210 and cover an upper surface of the capacitor dielectric layer 220. The upper electrode 230 may include impurity-doped polysilicon or impurity-doped poly-SiGe.

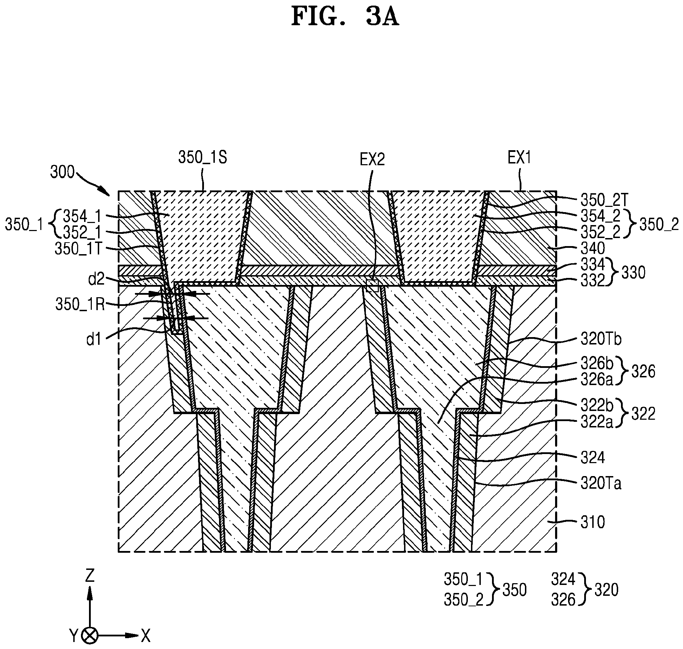

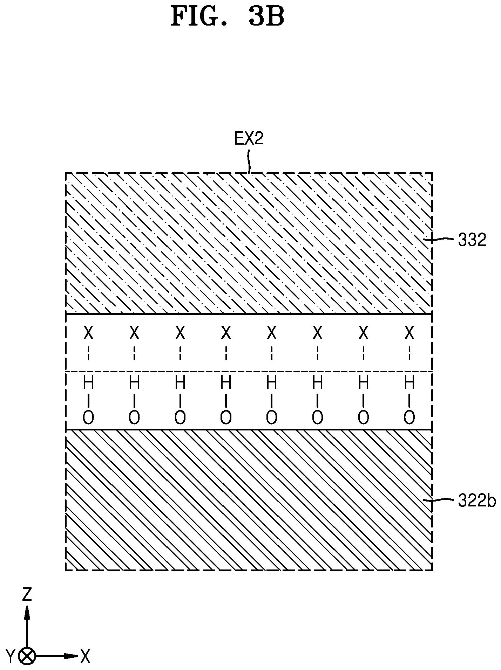

A wiring structure 300 may be on the capacitor structure 200. Hereinafter, the wiring structure 300 is described with reference to FIGS. 2A, 3A, and 3B.

FIG. 3A is a magnified cross-sectional view of region EX1 of FIG. 2A, and FIG. 3B is a magnified cross-sectional view of region EX2 of FIG. 3A.

Referring to FIGS. 2A, 3A, and 3B, the wiring structure 300 may include a lower insulating layer 310, a lower wiring structure 320, a spacer 322, a capping insulating layer 330, an upper insulating layer 340, and a via structure 350.

The lower insulating layer 310 may include an oxide layer or a low-k layer. A low-k layer may be a layer which has a dielectric constant that is lower than that of silicon oxide. In an implementation, the lower insulating layer 310 may include, e.g., an oxide layer, such as a borophosphosilicate glass (BPSG) layer, a phosphosilicate glass (PSG) layer, a borosilicate glass (BSG) layer, an undoped silicate glass (USG) layer, a tetra ethyl ortho silicate (TEOS) layer, or a high density plasma (HDP) layer, or a low-k layer, such as a silicon oxycarbide (SiOC) layer or a hydrogenated oxidized silicon carbon (SiCOH) layer, having an ultra low dielectric constant K of about 2.2 to about 2.4.

The lower insulating layer 310 may include a lower wiring via trench 320Ta and a lower wiring line trench 320Tb. Each of the lower wiring via trench 320Ta and the lower wiring line trench 320Tb may pass through the lower insulating layer 310 in the vertical direction (the Z direction). A bottom surface or end of the lower wiring via trench 320Ta may expose the upper electrode 230. The lower wiring via trench 320Ta may communicate with (e.g., may be continuous with) the lower wiring line trench 320Tb.

The spacer 322 may be on an inner wall of the lower wiring via trench 320Ta and an inner wall of the lower wiring line trench 320Tb. In an implementation, a lower spacer 322a may be on the inner wall of the lower wiring via trench 320Ta, and an upper spacer 322b may be on the inner wall of the lower wiring line trench 320Tb. The lower spacer 322a and the upper spacer 322b may surround a side wall of the lower wiring structure 320 inside the lower wiring via trench 320Ta and the lower wiring line trench 320Tb. The lower spacer 322a may be separated from the upper spacer 322b. In an implementation, a horizontal width of the upper spacer 322b may be about 10 nm to about 30 nm (e.g. the horizontal width of the upper spacer 322b may be in the range of 10 nm to 30 nm). In an implementation, the horizontal width of the upper spacer 322b may be about 20 nm (e.g. the horizontal width of the upper spacer 322b may be 20 nm). In an implementation, each of the lower spacer 322a and the upper spacer 322b may include silicon carbonitride (SiCN), SiN, SiO₂, SiON, silicon oxycarbonitride (SiOCN), or a combination thereof. In an implementation, the lower spacer 322a and the upper spacer 322b may include the same material. In an implementation, the lower spacer 322a and the upper spacer 322b may include SiCN.

The lower wiring structure 320 may be inside the lower wiring via trench 320Ta and the lower wiring line trench 320Tb. In an implementation, the lower wiring structure 320 may have a tapered shape of which a horizontal width decreases towards the capacitor structure 200. The lower wiring structure 320 may include a barrier layer 324 and a lower wiring metal layer 326.

The barrier layer 324 may be on an inner wall of the spacer 322 and the bottom surface of the lower wiring via trench 320Ta. In an implementation, the barrier layer 324 may include a metal, metal nitride, or a combination thereof. In an implementation, the metal may be, e.g., Ta or Ti, and the metal nitride may be, e.g., TaN or TiN. The lower wiring metal layer 326 may fill a space inside or formed by the barrier layer 324. The lower wiring metal layer 326 may include a lower wiring via 326a and a lower wiring line 326b. The lower wiring via 326a may fill the inside of the lower wiring via trench 320Ta and may be electrically connected to the upper electrode 230 of the capacitor structure 200. The lower wiring line 326b may fill the inside of the lower wiring line trench 320Tb and may be electrically connected to the via structure 350. The lower wiring via 326a and the lower wiring line 326b may be integrally formed. In an implementation, each of the lower wiring via 326a and the lower wiring line 326b may include Ti, TiN, Ta, TaN, W, WN, TiSiN, WSiN, or a combination thereof.

The capping insulating layer 330 may be on the lower insulating layer 310 and the lower wiring structure 320. The capping insulating layer 330 may include a first capping insulating layer 332 and a second capping insulating layer 334 sequentially on an upper surface of the lower insulating layer 310 and an upper surface of the lower wiring structure 320. In an implementation, the upper spacer 322b and the first capping insulating layer 332 may be connected to each other by hydrogen bonding. In an implementation, as shown in FIG. 3B, an upper surface of the upper spacer 322b may be hydrophilized to have hydroxyl (-OH) groups, and the upper spacer 322b and the first capping insulating layer 332 may be connected to each other by hydrogen bonding between the -OH groups and a material X of the first capping insulating layer 332. In an implementation, X indicates a material enabling or facilitating hydrogen bonding with the -OH groups in a material forming the first capping insulating layer 332. In an implementation, when the first capping insulating layer 332 includes SiN, N corresponds to X shown in FIG. 3B. Hydrophilization may be the process of making a material (in this case, the upper surface of the upper spacer 322b) more hydrophilic. In certain implementations, hydrophilization may involve hydroxylation in order to introduce hydroxyl (-OH) groups. In alternative implementations, hydrophilization may involve amination to introduce amino (-NH₂) groups. Through hydrophilization, the upper surface of the upper spacer 322b may be made hydrophilic to enable hydrogen bonds to be formed with the first capping insulating layer 332. The upper spacer 322b and the first capping insulating layer 332 may be connected to each other by hydrogen bonding, and the structural reliability of the wiring structure 300 may be further improved.

In an implementation, each of the first capping insulating layer 332 and the second capping insulating layer 334 may include SiCN, SiN, SiO₂, SiON, SiOCN, or a combination thereof. In an implementation, the first capping insulating layer 332 and the second capping insulating layer 334 may include different materials. In an implementation, the first capping insulating layer 332 may include a SiCN layer, and the second capping insulating layer 334 may include a SiN layer.

The upper insulating layer 340 may be on the second capping insulating layer 334. The upper insulating layer 340 may include, e.g., SiCN, SiN, SiO₂, SiON, SiOCN, or a combination thereof. In an implementation, the upper insulating layer 340 and the second capping insulating layer 334 may include different materials. In an implementation, the second capping insulating layer 334 may include a SiN layer, and the upper insulating layer 340 may include a SiO₂ layer.

The via structure 350 may extend in the vertical direction (the Z direction) and may pass through the upper insulating layer 340 and the capping insulating layer 330. The via structure 350 may be electrically connected to the lower wiring structure 320. The via structure 350 may include a first via structure 350_1 and a second via structure 350_2.

The first via structure 350_1 may be inside a first via trench 350_1T. The first via structure 350_1 may include a first via barrier layer 352_1 covering an inner wall of the first via trench 350_1T and a first via metal layer 354_1 filling an empty space inside the first via barrier layer 352_1. The first via structure 350_1 may be a misaligned via structure (e.g. a portion of the first via structure 350_1 may extend beyond the lower wiring structure 320 in a horizontal direction). In an implementation, a portion of the first via structure 350_1 may overlap the lower wiring structure 320 in the vertical direction (the Z direction), and the other portion of the first via structure 350_1 may overlap the upper spacer 322b in the vertical direction (the Z direction). The first via structure 350_1 may include a central portion 350_1S and a protruding portion 350_1R protruding from the central portion 350_1S in the vertical direction (the Z direction). Herein, the central portion 350_1S and the protruding portion 350_1R are defined for convenience of description, and the central portion 350_1S and the protruding portion 350_1R may be integrally formed. The central portion 350_1S may be a portion of the first via structure 350_1 on an upper surface of the lower wiring structure 320, and the protruding portion 350_1R may be a portion of the first via structure 350_1 beneath a level of the upper surface of the lower wiring structure 320 (i.e., a portion extending in the vertical direction (the Z direction) and passing through the upper spacer 322b). One side wall of the protruding portion 350_1R may be in contact with the barrier layer 324, and the other side wall of the protruding portion 350_1R may be in contact with the upper spacer 322b.

In an implementation, a horizontal width d2 of the protruding portion 350_1R may be less than a horizontal width d1 of the upper spacer 322b. In an implementation, a lower surface of the protruding portion 350_1R may be between the upper surface of the upper spacer 322b and a lower surface of the upper spacer 322b. In an implementation, the protruding portion 350_1R may not extend in the vertical direction (the Z direction) or the horizontal direction (the X or Y direction) over the upper spacer 322b.

The second via structure 350_2 may be inside a second via trench 350_2T. The second via structure 350_2 may include a second via barrier layer 352_2 covering an inner wall of the second via trench 350_2T and a second via metal layer 354_2 filling an empty space inside the second via barrier layer 352_2.

The second via structure 350_2 may overlap the lower wiring structure 320 in the vertical direction (the Z direction). In an implementation, unlike the first via structure 350_1, the second via structure 350_2 may not overlap the upper spacer 322b in the vertical direction (the Z direction).

In an implementation, each of the first via barrier layer 352_1 and the second via barrier layer 352_2 may include Ta, Ti, TaN, TiN, or a combination thereof.

In an implementation, each of the first via metal layer 354_1 and the second via metal layer 354_2 may include Ti, TiN, Ta, TaN, W, WN, TiSiN, WSiN, or a combination thereof.

In some wiring structures, a spacer surrounding a lower structure may not be separately included. Accordingly, if a via structure were to be misaligned such that a portion of the via structure is on a lower insulating layer, the via structure could be delaminated from an interface at which the via structure is in contact with the lower insulating layer, or a material forming the via structure could chemically react with a material forming the lower insulating layer such that a via metal layer of the via structure is hardly filled.

A structure in which a heterogeneous insulating layer is on the lower insulating layer has been considered. A profile of a lower wiring structure could be poor due to an etching rate difference between the lower insulating layer and the heterogeneous insulating layer, and a breakdown voltage (BV) between adjacent lower wiring structures could decrease due to the presence of the heterogeneous insulating layer having a relatively high dielectric constant.

The wiring structure 300 according to an embodiment may include the spacer 322 surrounding the wiring structure 300. Accordingly, even if the via structure 350 were to be misaligned such that a portion of the via structure 350 is on the lower insulating layer 310, the first and second via metal layers 354_1 and 354_2 may fill the insides of the first and second via trenches 350_1T and 350_2T well, respectively, and thus, the via structure 350 may not be delaminated from an interface at which the via structure 350 is in contact with the lower insulating layer 310. In addition, the wiring structure 300 may not separately include a heterogeneous insulating layer, a profile defect of the lower wiring structure 320 may not occur, and a decrease in a BV between adjacent lower wiring structures 320 may be prevented. Accordingly, the structural reliability of the semiconductor device 10 including the wiring structure 300 according to an embodiment may be improved.

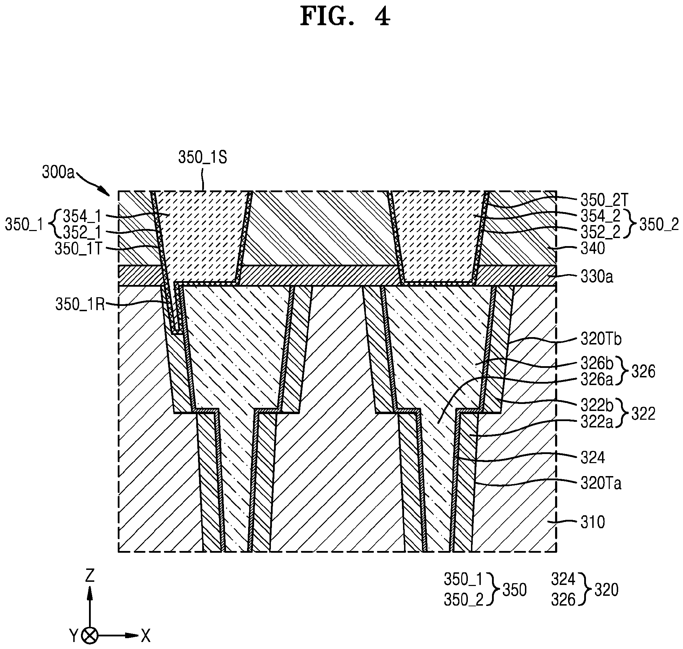

FIG. 4 is a cross-sectional view illustrating a wiring structure 300a according to an embodiment. Particularly, FIG. 4 is a cross-sectional view illustrating a region of the wiring structure 300a corresponding to the region EX1 of FIG. 2A. Each component of the wiring structure 300a illustrated in FIG. 4 is similar to each component of the wiring structure 300 described with reference to FIGS. 2A to 3B, and thus, differences therebetween are mainly described below.

Referring to FIG. 4, the wiring structure 300a may include the lower insulating layer 310, the lower wiring structure 320, the spacer 322, a capping insulating layer 330a, the upper insulating layer 340, and the via structure 350.

The capping insulating layer 330a may be on the lower insulating layer 310 and the lower wiring structure 320. In an implementation, the capping insulating layer 330a may include SiCN, SiN, SiO₂, SiON, or SiOCN. In an implementation, the capping insulating layer 330a may include a single insulating layer. In an implementation, the capping insulating layer 330a may include a SiN layer only. In an implementation, the upper spacer 322b and the capping insulating layer 330a may be connected to each other by hydrogen bonding. In an implementation, as described above with reference to FIG. 3B, the upper surface of the upper spacer 322b may be hydrophilized to have -OH groups, and the upper spacer 322b and the capping insulating layer 330a may be connected to each other by hydrogen bonding between the -OH groups and a material of the capping insulating layer 330a.

The upper insulating layer 340 may be on the capping insulating layer 330a. In an implementation, the capping insulating layer 330a and the upper insulating layer 340 may include different materials. In an implementation, the capping insulating layer 330a may include SiN, and the upper insulating layer 340 may include a SiO₂ layer.

The via structure 350 may extend in the vertical direction (the Z direction) and may pass through the upper insulating layer 340 and the capping insulating layer 330a.

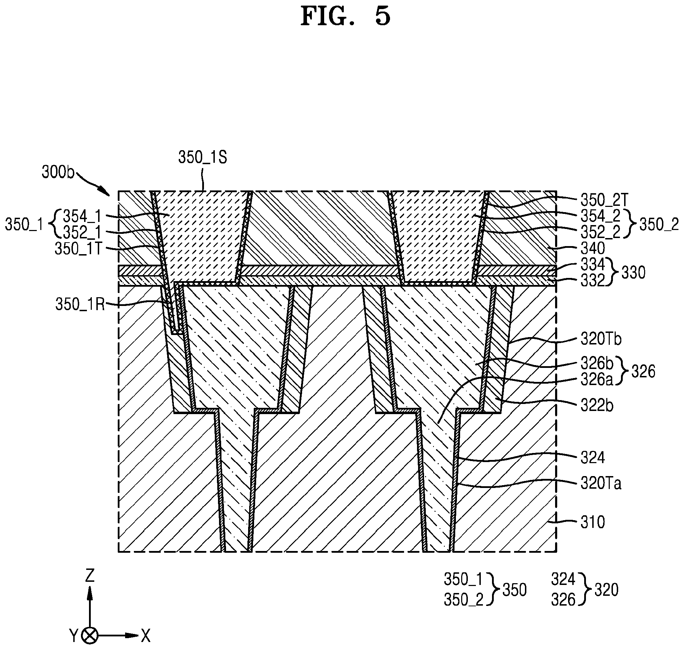

FIG. 5 is a cross-sectional view illustrating a wiring structure 300b according to an embodiment. Particularly, FIG. 5 is a cross-sectional view illustrating a region of the wiring structure 300b corresponding to the region EX1 of FIG. 2A. Each component of the wiring structure 300b illustrated in FIG. 5 is similar to each component of the wiring structure 300 described with reference to FIGS. 2A to 3B, and thus, differences therebetween are mainly described below.

Referring to FIG. 5, the wiring structure 300b may include the lower insulating layer 310, the lower wiring structure 320, the upper spacer 322b, the capping insulating layer 330, the upper insulating layer 340, and the via structure 350.

The upper spacer 322b may be on the inner wall of the lower wiring line trench 320Tb in the lower insulating layer 310. In an implementation, compared to the wiring structure 300 illustrated in FIG. 3A, the wiring structure 300b illustrated in FIG. 5B may not include the lower spacer 322a. In an implementation, the upper spacer 322b, the barrier layer 324, and the lower wiring line 326b may be sequentially on the inner wall of the lower wiring line trench 320Tb, and the barrier layer 324 and the lower wiring via 326a may be sequentially on the inner wall of the lower wiring via trench 320Ta.

A structure of the wiring structure 300b may be obtained by first forming the lower wiring line trench 320Tb in the lower insulating layer 310, then forming a spacer material layer so as to cover the inner wall of the lower wiring line trench 320Tb, forming the lower wiring via trench 320Ta below the lower wiring line trench 320Tb, and then sequentially forming the barrier layer 324 and the lower wiring metal layer 326 on the inner wall of the lower wiring via trench 320Ta and the inner wall of the lower wiring line trench 320Tb.

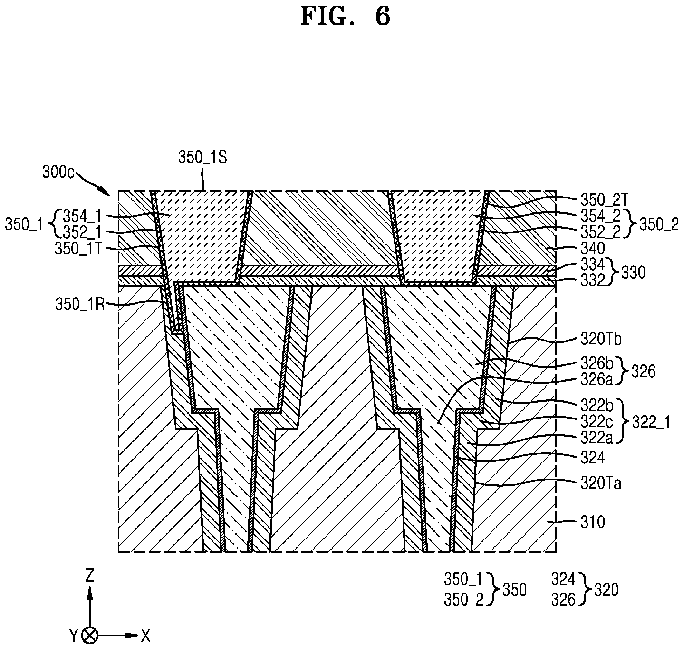

FIG. 6 is a cross-sectional view illustrating a wiring structure 300c according to an embodiment. Particularly, FIG. 6 is a cross-sectional view illustrating a region of the wiring structure 300c corresponding to the region EX1 of FIG. 2A. Each component of the wiring structure 300c illustrated in FIG. 6 is similar to each component of the wiring structure 300 described with reference to FIGS. 2A to 3B, and thus, differences therebetween are mainly described below.

Referring to FIG. 6, the wiring structure 300c may include the lower insulating layer 310, the lower wiring structure 320, a spacer 322_1, the capping insulating layer 330, the upper insulating layer 340, and the via structure 350.

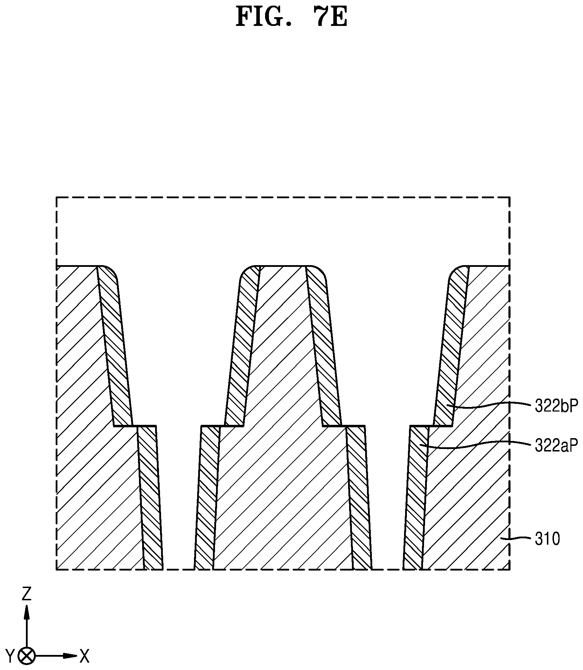

The spacer 322_1 may be on the inner wall of the lower wiring via trench 320Ta and the inner wall of the lower wiring line trench 320Tb in the lower insulating layer 310. The spacer 322_1 may include the lower spacer 322a on the inner wall of the lower wiring via trench 320Ta, the upper spacer 322b on the inner wall of the lower wiring line trench 320Tb, and a central spacer 322c connecting the lower spacer 322a to the upper spacer 322b. In an implementation, each of the lower spacer 322a, the upper spacer 322b, and the central spacer 322c may include SiCN, SiN, SiO₂, SiON, SiOCN, or a combination thereof. In an implementation, the lower spacer 322a, the upper spacer 322b, and the central spacer 322c may include the same material. For example, the lower spacer 322a, the upper spacer 322b, and the central spacer 322c may include SiCN. A structure of the wiring structure 300c may be obtained by adjusting an etch-back process to be described below with reference to FIG. 7E.

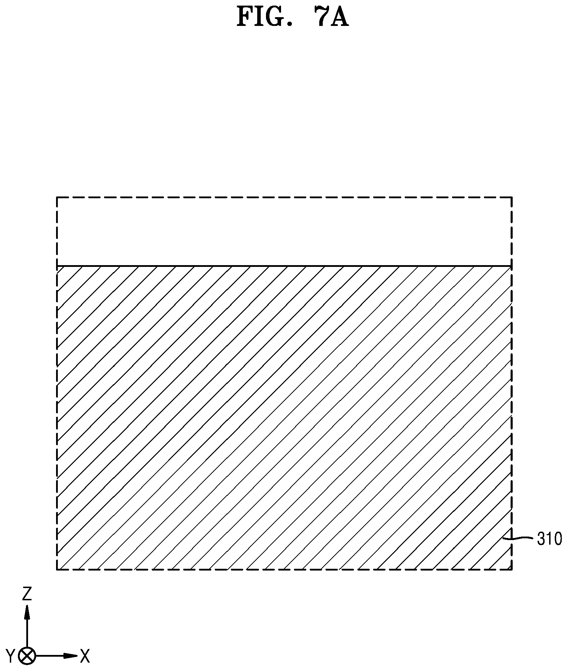

FIGS. 7A to 7H are cross-sectional views of stages in a method of manufacturing the wiring structure 300, according to an embodiment.

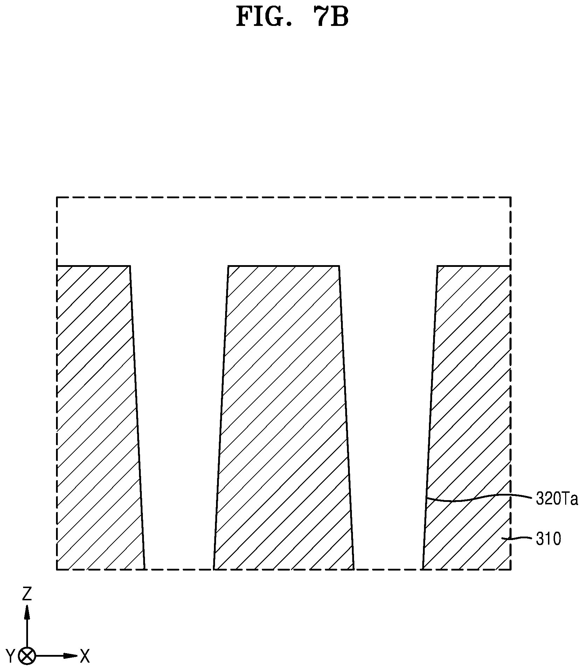

Referring to FIGS. 7A and 7B, first, the lower insulating layer 310 may be formed. Next, a first mask pattern may be formed on the lower insulating layer 310, and then the lower wiring via trench 320Ta passing through the lower insulating layer 310 may be formed using the first mask pattern. In this case, the upper electrode 230 (see FIG. 2A) may be exposed through or at the bottom surface of the lower wiring via trench 320Ta. The first mask pattern may include, e.g., an amorphous carbon layer (ACL) or a spin on hardmask (SOH).

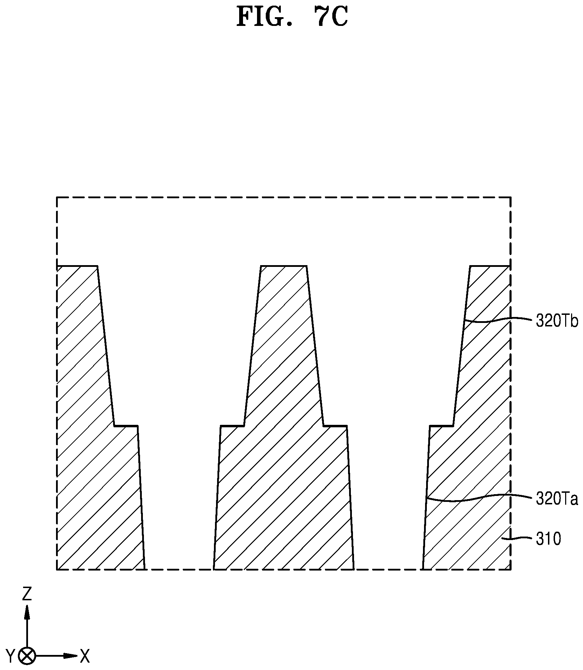

Referring to FIG. 7C, in a result of FIG. 7B, a second mask pattern may be formed on the lower insulating layer 310, and then the lower wiring line trench 320Tb passing through a portion of an upper region of the lower insulating layer 310 may be formed using the second mask pattern. In this case, a horizontal width of the lower wiring via trench 320Ta may be less than a horizontal width of the lower wiring line trench 320Tb. The second mask pattern may include, e.g., an ACL or an SOH.

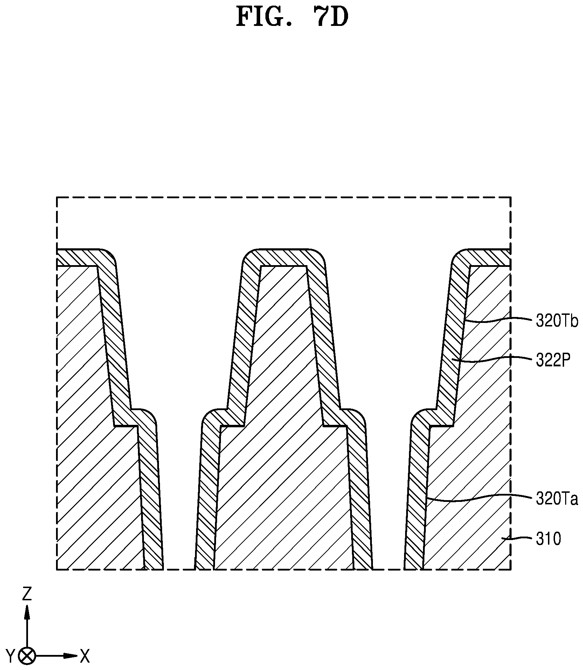

Referring to FIG. 7D, in a result of FIG. 7C, a spacer material layer 322P may be formed on the inner wall of the lower wiring via trench 320Ta and the inner wall of the lower wiring line trench 320Tb.

Referring to FIG. 7E, in a result of FIG. 7D, an etch-back process may be performed to etch the spacer material layer 322P (see FIG. 7D). By the etch-back process, a portion of the spacer material layer 322P, which is formed on the bottom surface of the lower wiring line trench 320Tb (see FIG. 7D), may be removed, and only a first spacer material layer 322aP on the inner wall of the lower wiring via trench 320Ta and a second spacer material layer 322bP on the inner wall of the lower wiring line trench 320Tb may remain.

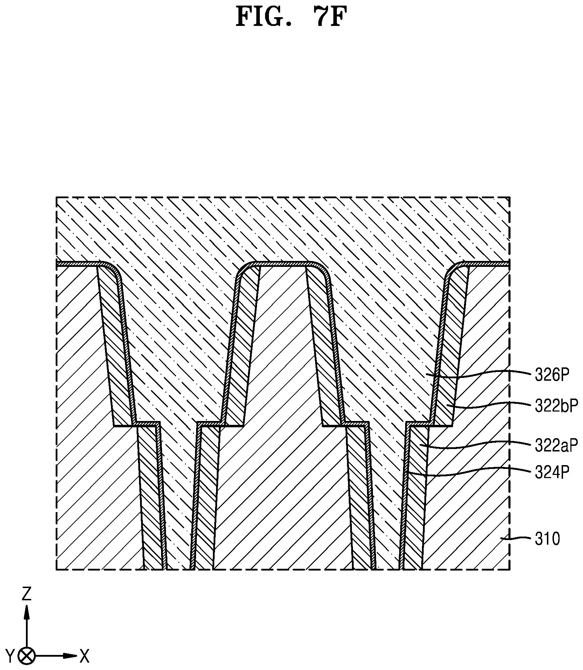

Referring to FIG. 7F, in a result of FIG. 7E, a barrier material layer 324P may be formed on the inner wall of the lower wiring via trench 320Ta and the inner wall of the lower wiring line trench 320Tb, and then a metal material layer 326P may fill an empty space inside the barrier material layer 324P.

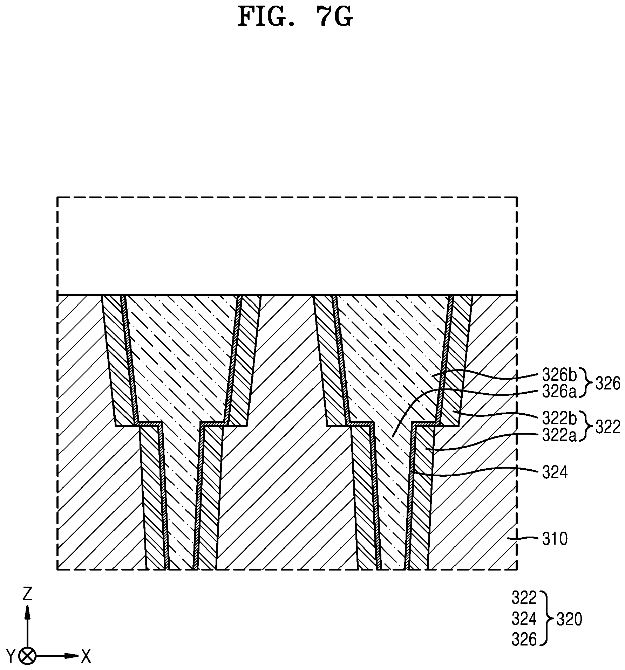

Referring to FIG. 7G, in a result of FIG. 7F, a planarization process may be performed. The planarization process may be, e.g., a chemical mechanical polishing (CMP) process. As a result of the planarization process, portions of the metal material layer 326P (see FIG. 7F), the second spacer material layer 322bP (see FIG. 7F), and the barrier material layer 324P (see FIG. 7F) may be removed, thereby forming the lower wiring metal layer 326, the barrier layer 324, and the upper spacer 322b. In an implementation, an upper surface of the lower wiring metal layer 326, an upper surface of the barrier layer 324, and the upper surface of the upper spacer 322b may be coplanar with each other. In addition, the first spacer material layer 322aP (see FIG. 7F) may function as the lower spacer 322a. Next, the upper surface of the upper spacer 322b may be hydrophilized. As a result of the hydrophilization, the upper surface of the upper spacer 322b may have the -OH groups as shown in FIG. 3B.

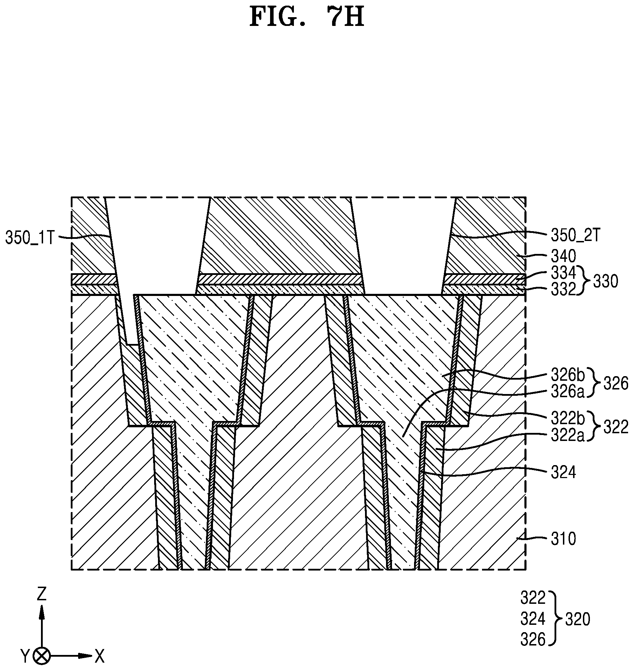

Referring to FIG. 7H, in a result of FIG. 7G, the first capping insulating layer 332 and the second capping insulating layer 334 may be first sequentially formed on the upper surface of the lower insulating layer 310 and the upper surface of the lower wiring structure 320, and then the upper insulating layer 340 may be formed on the second capping insulating layer 334. Next, the first via trench 350_1T and the second via trench 350_2T extending in the vertical direction (the Z direction) and passing through the upper insulating layer 340, the second capping insulating layer 334, and the first capping insulating layer 332 may be formed. A portion of the first via trench 350_1T may overlap the lower wiring structure 320 in the vertical direction (the Z direction), and the other portion of the first via trench 350_1T may overlap the upper spacer 322b in the vertical direction (the Z direction). In this case, the other portion of the first via trench 350_1T overlapping the upper spacer 322b in the vertical direction (the Z direction) may extend in the vertical direction (the Z direction) and pass through or into the upper spacer 322b. In an implementation, the other portion of the first via trench 350_1T may extend in the vertical direction (the Z direction) and pass through the upper insulating layer 340, the second capping insulating layer 334, the first capping insulating layer 332, and at least a portion of the upper spacer 322b. The second via trench 350_2T may overlap the lower wiring structure 320 in the vertical direction (the Z direction).

Next, in a result of FIG. 7H, the first via barrier layer 352_1 may be formed on the inner wall of the first via trench 350_1T, and the second via barrier layer 352_2 may be formed on the inner wall of the second via trench 350_2T. Next, a space inside the first via barrier layer 352_1 may be filled with the first via metal layer 354_1, and a space inside the second via barrier layer 352_2 may be filled with the second via metal layer 354_2, thereby forming the wiring structure 300 illustrated in FIG. 3A.

One or more embodiments may provide a wiring structure including a spacer.

One or more embodiments may provide a wiring structure with improved structural reliability.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

Embodiments are set out in the following clauses:
1. A wiring structure, comprising:
   a lower insulating layer
   a lower wiring structure extending in a vertical direction and passing through the lower insulating layer;
   a spacer surrounding a side wall of the lower wiring structure;
   a capping insulating layer on the lower insulating layer; and
   a via structure extending in the vertical direction and passing through the capping insulating layer,
   wherein:
      the via structure overlaps the lower wiring structure and the spacer in the vertical direction, and
      the via structure includes a protruding portion extending in the vertical direction and passing through at least a portion of the spacer.
2. The wiring structure of clause 1, wherein the spacer and the capping insulating layer include a same material.
3. The wiring structure of clause 1 or clause 2, wherein the spacer and the capping insulating layer each include silicon carbonitride (SiCN), silicon nitride (SiN), silicon oxide (SiO2), silicon oxynitride (SiON), silicon oxycarbonitride (SiOCN), or a combination thereof.
4. The wiring structure of any preceding clause, wherein a horizontal width of the protruding portion is less than a horizontal width of the spacer.
5. The wiring structure of any preceding clause, wherein a lower surface of the protruding portion is between an upper surface of the spacer and a lower surface of the spacer in the vertical direction.
6. The wiring structure of any preceding clause, wherein a horizontal width of the spacer is about 10 nm to about 30 nm.
7. The wiring structure of any preceding clause, wherein:
   the spacer includes an upper spacer adjacent to the capping insulating layer and a lower spacer below the upper spacer, and
   the protruding portion extends in the vertical direction and passes through at least a portion of the upper spacer.
8. The wiring structure of clause 7, wherein the lower spacer and the upper spacer include a same material.
9. The wiring structure of any preceding clause, wherein:
   the capping insulating layer includes a first capping insulating layer on the lower insulating layer and a second capping insulating layer on the first capping insulating layer,
   each of the first capping insulating layer and the second capping insulating layer independently includes silicon carbonitride (SiCN), silicon nitride (SiN), silicon oxide (SiO2), silicon oxynitride (SiON), silicon oxycarbonitride (SiOCN), or a combination thereof, and
   the first capping insulating layer includes a material different from a material of the second capping insulating layer.
10. The wiring structure of clause 9, wherein the first capping insulating layer and the spacer include a same material.
11. A semiconductor device, comprising:
   a substrate;
   a plurality of capacitor structures including a plurality of lower electrodes on the substrate, a capacitor dielectric layer covering the plurality of lower electrodes, and an upper electrode filling a space between the plurality of lower electrodes and covering an upper surface of the capacitor dielectric layer; and
   a wiring structure on and connected to the plurality of capacitor structures,
   wherein the wiring structure includes:
      a lower insulating layer on the substrate;
      a lower wiring structure extending in a vertical direction and passing through the lower insulating layer;
      a spacer surrounding a side wall of the lower wiring structure;
      a capping insulating layer on the lower insulating layer; and
      a via structure extending in the vertical direction and passing through the capping insulating layer,
      wherein:
         the via structure overlaps the lower wiring structure and the spacer in the vertical direction, and
         the via structure includes a protruding portion extending in the vertical direction and passing through at least a portion of the spacer.
12. The semiconductor device of clause 11, wherein the spacer and the capping insulating layer include a same material.
13. The semiconductor device of clause 11 or clause 12, wherein the spacer and the capping insulating layer each include silicon carbonitride (SiCN), silicon nitride (SiN), silicon oxide (SiO2), silicon oxynitride (SiON), silicon oxycarbonitride (SiOCN), or a combination thereof.
14. The semiconductor device of any of clauses 11-13, wherein the spacer and the capping insulating layer are bonded to each other by hydrogen bonding.
15. The semiconductor device of any of clauses 11-14, wherein the spacer has a hydrophilized upper surface.

## Claims

1. A wiring structure, comprising:
a lower insulating layer;
a lower wiring structure extending in a vertical direction and passing through the lower insulating layer;
a spacer surrounding a side wall of the lower wiring structure;
a capping insulating layer on the lower insulating layer; and
a via structure extending in the vertical direction and passing through the capping insulating layer,
wherein:
the via structure overlaps the lower wiring structure and the spacer in the vertical direction, and
the via structure includes a protruding portion extending in the vertical direction and passing through at least a portion of the spacer.

2. The wiring structure as claimed in claim 1, wherein the spacer and the capping insulating layer include a same material.

3. The wiring structure as claimed in claim 1 or claim 2, wherein the spacer and the capping insulating layer each include silicon carbonitride, silicon nitride, silicon oxide, silicon oxynitride, silicon oxycarbonitride, or a combination thereof.

4. The wiring structure as claimed in any preceding claim, wherein a horizontal width of the protruding portion is less than a horizontal width of the spacer.

5. The wiring structure as claimed in any preceding claim, wherein a lower surface of the protruding portion is between an upper surface of the spacer and a lower surface of the spacer in the vertical direction.

6. The wiring structure as claimed in any preceding claim, wherein a horizontal width of the spacer is about 10 nm to about 30 nm.

7. The wiring structure as claimed in any preceding claim, wherein:
the spacer includes an upper spacer adjacent to the capping insulating layer and a lower spacer below the upper spacer, and
the protruding portion extends in the vertical direction and passes through at least a portion of the upper spacer.

8. The wiring structure as claimed in claim 7, wherein the lower spacer and the upper spacer include a same material.

9. The wiring structure as claimed in any preceding claim, wherein:
the capping insulating layer includes a first capping insulating layer on the lower insulating layer and a second capping insulating layer on the first capping insulating layer,
each of the first capping insulating layer and the second capping insulating layer independently includes silicon carbonitride, silicon nitride, silicon oxide, silicon oxynitride, silicon oxycarbonitride, or a combination thereof, and
the first capping insulating layer includes a material different from a material of the second capping insulating layer.

10. The wiring structure as claimed in claim 9, wherein the first capping insulating layer and the spacer include a same material.

11. The wiring structure as claimed in any preceding claim, wherein the spacer and the capping insulating layer are bonded to each other by hydrogen bonding.

12. The wiring structure as claimed in any preceding claim, wherein the spacer has a hydrophilized upper surface.

13. A semiconductor device, comprising:
a substrate;
a plurality of capacitor structures including a plurality of lower electrodes on the substrate, a capacitor dielectric layer covering the plurality of lower electrodes, and an upper electrode filling a space between the plurality of lower electrodes and covering an upper surface of the capacitor dielectric layer; and
a wiring structure according to any preceding claim, wherein:
the wiring structure is on and connected to the plurality of capacitor structures, and
the lower insulating layer is on the substrate .
